Europäisches Patentamt

European Patent Office

Office européen des brevets

(19)

(11) **EP 0 675 347 B1**

(12) **FASCICULE DE BREVET EUROPEEN**

(45) Date de publication et mention
de la délivrance du brevet:
**14.05.2003 Bulletin 2003/20**

(51) Int Cl.[7]: **G01K 7/20**, G01R 27/02

(21) Numéro de dépôt: **95400477.6**

(22) Date de dépôt: **06.03.1995**

(54) **Circuit de mesure d'une grandeur physique**

Schaltung zur Messung einer physikalischen Grösse

Circuit for measuring a physical quantity

(84) Etats contractants désignés:
**DE ES FR GB IT**

(30) Priorité: **01.04.1994 FR 9403878**

(43) Date de publication de la demande:
**04.10.1995 Bulletin 1995/40**

(73) Titulaire: **SCHLUMBERGER INDUSTRIES S.A.**
**92120 Montrouge (FR)**

(72) Inventeurs:
• **Macel, Pierre**
**F-75007 Paris (FR)**

• **Gervais, Michel**
**F-94500 Champigny Sur Marne (FR)**

(74) Mandataire: **Feray, Valérie et al**
**Feray Lenne Conseil**
**44/52, Rue de la Justice**
**75020 Paris (FR)**

(56) Documents cités:
**EP-A- 0 173 833**          **DE-A- 3 009 444**
**US-A- 4 504 922**          **US-A- 4 910 689**
**US-A- 5 255 975**

## Description

La présente invention concerne un circuit de mesure d'une grandeur physique, en particulier apte à être utilisé avec un microprocesseur, comprenant un condensateur, qui est chargé ou déchargé en utilisant une résistance de référence et une résistance de mesure, la résistance de mesure ayant une valeur qui dépend de la grandeur physique mesurée (température, humidité, pression etc), et un dispositif de contrôle qui contrôle et mesure le temps de charge ou décharge du condensateur.

Dans la réalisation la plus simple, un circuit de mesure de température de ce type comprend une thermistance et une résistance de référence reliée en parallèle et un condensateur relié en série avec les résistances. Le condensateur est chargé via la thermistance et via la résistance de référence et le temps de charge du condensateur via la thermistance est comparé avec le temps de charge en utilisant la résistance de référence pour calculer la température. La commutation des résistances, la mesure du temps de charge et l'alimentation du circuit peuvent être réalisées en utilisant les bornes d'un microprocesseur. Ces capteurs de température sont particulièrement utiles dans des systèmes de régulation d'une installation de chauffage où le microprocesseur peut avoir plusieurs fonctions, y compris une horloge ou des moyens de contrôle d'un élément de chauffage. D'autres domaines d'application de ces circuits peuvent inclure des appareils électroménager en général, la mesure de la température extérieure à un véhicule, la mesure de la température de fluides etc.

Des problèmes de calibration des circuits de ce type se présentent souvent et, pour les surmonter des systèmes comprenant plusieurs résistances de référence et utilisant plusieurs mesures du temps de charge ou décharge du condensateur ont été proposés, par exemple, dans des demandes de brevets EP 0 524 086 et FR 2 644 589. Un exemple d'un circuit de mesure de température utilisant plusieurs résistances et ayant une deuxième fonction est décrit dans le brevet FR 2 625 822.

La demande de brevet EP 0 524 086 décrit un système où le condensateur est chargé via une première résistance de référence, via une thermistance et la première résistance de référence en série, et via les deux résistances de référence en série. Ces mesures sont utilisées pour calculer la température. Le circuit du brevet FR 2 644 589 mesure le temps de charge d'un condensateur via trois résistances indépendamment. Le brevet FR 2 625 822 montre un circuit de mesure de température également comprenant un potentiomètre dans lequel le temps de charge ou décharge du condensateur est utilisé pour déterminer la valeur du potentiomètre. Tous ces systèmes sont relativement complexes et couteux au niveau des composants utilisés.

La présente invention est caractérisée en ce que le dispositif de contrôle est apte à contrôler et à mesurer le temps de charge ou décharge du condensateur en utilisant la résistance de mesure, en utilisant la résistance de référence, et en utilisant la résistance de mesure et la résistance de référence simultanément, la résistance de mesure et la résistance de référence étant aptes à être reliées en parallèle par le dispositif de contrôle pour la mesure des deux résistances ensemble, le dispositif de contrôle ainsi déterminant la valeur de la résistance de mesure et la valeur de la grandeur physique mesurée.

Ainsi, la présente invention fournit un système dans lequel des erreurs de calibration qui sont constantes pendant les trois mesures de temps de charge ou de décharge, par exemple dues à des fuites de courant dans le circuit, peuvent être éliminées par une étape de calcul.

Il est possible de relier la résistance de mesure et la résistance de référence en série pendant la mesure du temps de charge ou décharge utilisant les résistances ensemble. Cependant, dans ce cas, la commutation des résistances du circuit peut nécessiter un cablage et un circuit de commutation assez complexe. Dans le circuit de la présente invention, qui utilise des résistances en parallèle, il est plus facile de commuter entre les résistances et les problèmes au niveau du cablage du système sont évités.

L'invention est particulièrement pratique dans le cas où il faut mettre la résistance de mesure à une distance des autres éléments du circuit, et dans le cas où plusieurs résistances de mesure sont reliées en parallèle, qui sont commutées par le dispositif de contrôle pour que le temps de charge ou décharge de chaque résistance puisse être mesuré indépendamment pour déterminer la valeur de la grandeur physique mesurée à plusieurs endroits. Egalement, la connexion des résistances de mesure et de référence en parallèle minimise les effets de la résistance des commutateurs utilisés dans le circuit. Par contre, dans un système relié en série, la résistance due aux commutateurs dans le circuit augmente avec chaque résistance de mesure ajoutée au circuit. Cette résistance induit des erreurs (variables avec le temps) qui ne peuvent être compensées.

Dans un mode de réalisation, la résistance de mesure et la résistance de référence peuvent être reliées entre une source de tension ou courant et le condensateur pour que le condensateur soit chargé ou déchargé directement via les résistances. Selon un autre mode de réalisation, le condensateur est chargé ou déchargé par une source de courant, le courant fourni au condensateur étant contrôlé par un élément de contrôle (par exemple un transistor) associé avec chaque résistance et étant une image du courant circulant dans la résistance de mesure ou référence. Ce dernier mode est préféré pour assurer une vitesse de charge ou décharge constante.

La présente invention s'applique en particulier à la mesure de température, où la résistance de mesure a une valeur qui dépend de la température. Selon un mode de réalisation préféré, la résistance de mesure est une sonde platine. Ce choix de la résistance possède l'avantage de stabilité et facilite le calcul de la température par le dispositif de contrôle utilisant la valeur de la résistance déterminée. En général, avec une sonde platine, la variation de la résistance de la sonde avec la température peut être représentée par une courbe du second degré. Selon un mode de réalisation, le dispositif de contrôle calcule la témpérature par la solution d'une équation quadratique en utilisant la valeur de la résistance de la sonde. Cependant, pour simplifier cette étape de calcul le dispositif de contrôle peut calculer la température en utilisant une approximation linéaire de la variation de la résistance de la sonde avec la température.

L'invention sera mieux comprise à la lecture de la description qui suit d'un mode de réalisation de l'invention, donnée à titre d'exemple illustratif et non limitatif et faisant référence aux dessins annexés sur lesquels :

La Figure 1 est un schéma d'un circuit de mesure de température utilisant une résistance de référence et une résistance de mesure selon la présente invention.

La Figure 2 est un graphe montrant la relation entre la résistance et la température de la résistance de mesure utilisée dans le circuit de la Figure 1.

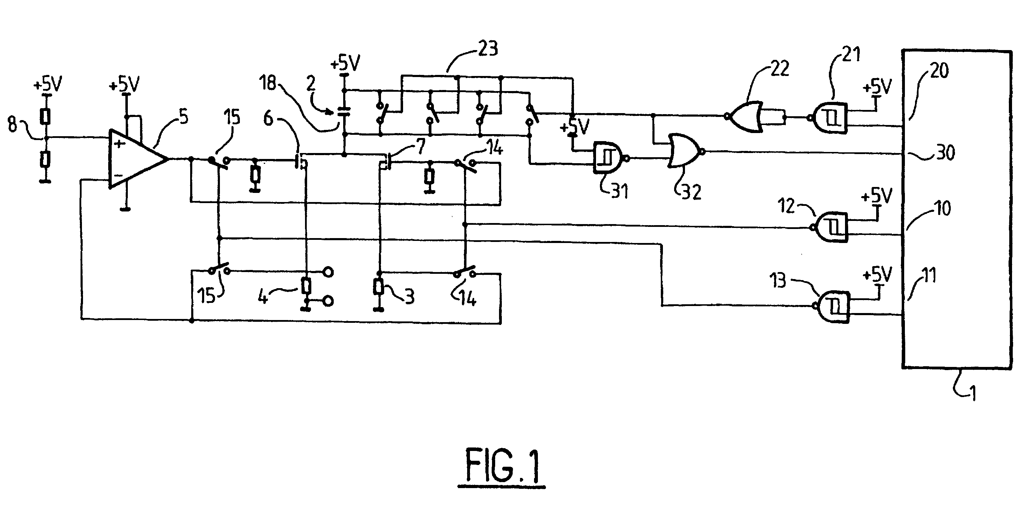

Comme le montre la Figure 1, un circuit mesure de température selon ce mode de réalisation de l'invention comprend un dispositif de contrôle 1, étant un microprocesseur, qui contrôle et mesure le temps de décharge d'un condensateur 2, une résistance de référence 3 et une résistance de mesure 4, la résistance de mesure étant une sonde platine, laquelle résistance dépend de la température. Au début d'une mesure le condensateur est relié à une tension de 5v et déchargé par les commutateurs 23. Il est chargé négativement pendant une mesure par les moyens d'une source de courant, étant un amplificateur 5, et les transistors 6 et 7. Tous les éléments du circuit, y compris l'amplificateur 5, qui est polarisé via un montage diviseur de tension 8, sont alimentés à une tension de 5 volts. Du fait de la faible consommation du montage, ils peuvent être alimentés par une borne du microprocesseur 1. La commutation de la résistance de référence et la résistance de mesure est contrôlée par les bornes 10, 11 du microprocesseur 1 via des circuits basculeurs 12, 13 et des commutateurs 14, 15. L'état du condensateur avant et après une étape de mesure est contrôlée par la borne 20 du microprocesseur qui envoie un signal via un circuit basculeur 21 et une porte NOR 22 pour fermer les commutateurs 23. Le temps de charge du condensateur est mesuré par la borne 30 du microprocesseur qui surveille la charge dans le condensateur et la tension de l'électrode 18 du condensateur via un circuit basculeur 31 et une porte NOR 32.

Lorsque les commutateurs utilisés dans le circuit sont des éléments d'un dispositif de commutation ayant huit bornes, quatre bornes du dispositif peuvent être utilisées en parallèle comme les commutateurs 23 pour surmonter des problèmes associés avec la résistance de chaque commutateur et pour assurer le court-circuit du condensateur. Les autres quatre bornes du dispositif de commutation sont utilisées pour les commutateurs 14, 15.

Avant le début d'une étape de mesure la borne du microprocesseur 1 est à 1 pour fermer les commutateurs 23 et pour que le condensateur 2 soit court-circuité. Les commutateurs 23 sont alors ouverts pour une mesure. Ainsi, au début d'une mesure le condensateur sera déchargé, la tension de l'électrode 18 étant 5v. Quand la mesure est terminée les condensateurs sont à nouveau court-circuités.

Pendant une première mesure, la résistance de référence 3 est sélectionnée par un signal de la borne 10 du microprocesseur qui ferme les commutateurs 14. L'électrode 18 du condensateur sera à une tension 5v. La tension à ce point évolue vers zéro, le courant circulant dans la résistance 3 étant copié par le transistor 7 et l'amplificateur 5 pour charger négativement le condensateur. Dès que la charge du condensateur passe sous le seuil du circuit basculeur 31 un signal est envoyé à la borne 30 du microprocesseur pour indiquer la fin de la mesure, le temps de charge du condensateur dépendant de la valeur de la résistance 3.

Le condensateur est alors court-circuité et déchargé par les commutateurs 23, l'électrode 18 revient à une tension de 5v, et la même étape est répétée pour la résistance de mesure, par l'envoi d'un signal de la borne 11 du microprocesseur. Après cette étape le temps de charge pour les deux résistances simultanément est mesuré, par l'envoi des signaux des deux bornes 10, 11 en même temps. La résistance de mesure étant une sonde platine, le temps de charge pendant ces deux dernières étapes dépendra de la température de la sonde.

Dans chaque cas le condensateur est chargé par un courant principal qui passe par le transistor activé et aussi par des courants de fuite des transistors. L'erreur de fuite introduite par chaque transistor sera pratiquement identique pendant toutes les mesures. Il y a également une erreur constante dûe à la charge initiale restant dans le condensateur après sa décharge. Les temps de charge du condensateur pendant les périodes de mesure peuvent être ainsi représentés par :

$$N_{ref} = K.\ R_{ref} + C$$

$$N_{sens} = K.\ R_{sens} + C$$

$$N_{par} = K.\ \frac{R_{ref}.\ R_{sens}}{R_{ref} + R_{sens}} + C$$

où $N_{ref}$, $N_{sens}$, $N_{par}$ sont les temps de décharge du condensateur mesurés par le microprocesseur en utilisant la résistance de référence, la résistance de mesure et les deux résistances ensemble, respectivement. Rref et Rsens sont les valeurs de la résistance de référence et la résistance de mesure, K est une constante dépendant du courant fourni par l'amplificateur, et C est une constante représentant des erreurs venant des non-linéarités dans le circuit, y compris les courants de fuite associés avec chaque transistor et la charge initiale dans le condensateur.

En fait, les valeurs des constantes K et C peuvent changer entre les mesures à cause des différences entre des composants mais les équations ci-dessus sont suffisantes pour représenter le comportement du système.

Des relations ci-dessous on tire :

$$Nref - Npar = \frac{K(Rref)^2}{Rref + Rsens}$$

$$Nsens - Npar = \frac{K(Rsens)^2}{Rref + Rsens}$$

D'où :

$$\frac{(Rsens)^2}{(Rref)^2} = \frac{Nsens - Npar}{Nref - Npar}$$

Et, ainsi :

$$Rsens = Rref \sqrt{\frac{Nsens - Npar}{Nref - Npar}}$$

Donc, si on connait la valeur de la résistance de référence on peut calculer la valeur de la résistance de mesure des valeurs de temps de décharge du condensateur. Les problèmes de calibration associés avec des valeurs inconnues dans le circuit, par exemple à cause des courants de fuite, sont éliminés pendant les étapes de calcul.

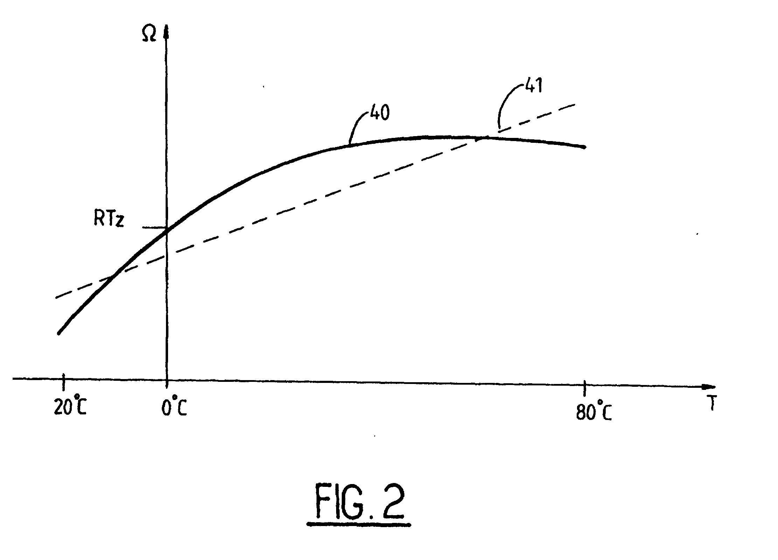

En se référant à la Figure 2, la relation entre la résistance de la sonde platine utilisée dans le circuit de la Figure 1 et la témpérature définie une courbe du second degré, montrée par la ligne solide 40, la courbe étant décrite par l'équation :

$$Rsens = R_{Tz} (1 + \alpha T - \beta T^2)$$

où $R_{Tz}$ est la résistance de la sonde à zéro degré centigrade, T est la température en degrés centigrade, et $\alpha$ et $\beta$ sont constants. Pour une sonde typique dans une plage de température normalement utilisé :

$$\alpha = 3.90784 \times 10^{-3}/°c$$

$$\beta = 0.578408 \times 10^{-6}/(°c)^2$$

$$R_{Tz} = 1000 \ \Omega$$

Ainsi, la valeur de température T correspondant à la valeur de la résistance de la sonde Tsens peut être calculée par la solution d'une équation quadratique. Cependant, pour simplifier le calcul, le comportement de la sonde peut être estimée par une relation linéaire, montrée dans la Figure 2 par la ligne 41. Pour une sonde ayant les caractéristiques données ci-dessus la relation suivante est utilisée :

$$T = \frac{Rsens - 999.65}{3.8847}$$

où les valeurs numériques sont exprimées dans les unités appropriées.

Cette simplification s'applique en particulier dans le cas où le circuit de mesure de température est utilisé pour mesurer les températures typique dans un appartement où une maison.

Le circuit de la figure 1 utilise une seule sonde de témpérature. Selon d'autres modes de réalisation, plusieurs sondes de température peuvent être connectées en parallèle avec la sonde de température et la résistance de référence existant. Dans ces modes de réalisation, une mesure est faite du temps de charge avec la résistance de référence, et, pour chaque sonde, deux mesures sont faites, en utilisant la sonde seule et en parallèle avec la résistance de référence.

D'autres modes de réalisation, où la sonde est remplacée par une résistance, dont la valeur dépend d'une autre grandeur physique, par exemple la pression ou l'humidité, sont également possibles.

## Revendications

1. Circuit de mesure d'une grandeur physique comprenant un condensateur (2), qui peut être chargé ou déchargé en utilisant une résistance de référence (3) et une résistance de mesure (4), la résistance de mesure ayant une valeur qui dépend de la valeur d'une grandeur physique, et un dispositif de contrôle (1) qui contrôle et mesure le temps de charge ou décharge du condensateur, **caractérisé en ce que** le dispositif de contrôle (1) est apte à contrôler et à mesurer le temps de charge ou décharge du condensateur en utilisant la résistance de mesure (4), en utilisant la résistance de référence (3), et en utilisant la résistance de mesure et la résistance de référence simultanément (3, 4), la résistance de mesure (4) et la résistance de référence (3) étant aptes à être reliées en parallèle par le dispositif de contrôle pour la mesure des deux résistances simultanément, le dispositif de contrôle ainsi déterminant la valeur de la résistance de mesure et la valeur de la grandeur physique mesurée.

2. Circuit de mesure selon la revendication 1 dans lequel plusieurs résistances de mesure sont aptes à être reliées en parallèle par le dispositif de contrôle.

3. Circuit de mesure selon la revendication 1 ou 2 dans lequel le condensateur (2) est chargé ou déchargé par une source de courant (5), le courant fourni au condensateur étant contrôlé par un élément de contrôle (6,7) associé avec chaque résistance (4,3) et étant une image du courant circulant dans cette résistance.

4. Circuit de mesure selon l'une quelconque des revendications 1 à 3 dans lequel la résistance de mesure (4) a une valeur qui dépend de la valeur de température.

5. Circuit de mesure selon la revendication 4 dans lequel la résistance de mesure (4) est une sonde platine.

6. Circuit de mesure de température selon la revendication 5 dans lequel le dispositif de contrôle calcule la témpérature par la solution d'une équation quadratique en utilisant la valeur de la résistance de la sonde.

7. Circuit de mesure de température selon la revendication 5 dans lequel le dispositif de contrôle calcule la température en utilisant une approximation linéaire de la variation de la résistance de la sonde avec la température.

8. Circuit de mesure de température selon l'une quelconque des revendications 1 à 6 dans lequel le dispositif de contrôle (1) est un microprocesseur.

**Patentansprüche**

1. Messkreis einer physikalischen Grösse mit einem Kondensator (2), der mittels eines Referenzwiderstands (3) und eines Messwiderstands (4) ge- und entladen werden kann, wobei der Messwiderstand einen Wert hat, der von dem Wert der physikalischen Grösse abhängt, und einem Kontrollbauelement (1), das die Lade- und Entladezeit des Kondensators kontrolliert und misst und **dadurch gekennzeichnet ist, dass** das Kontrollbauelement (1) in der Lage ist, die Lade- und Entladungszeit des Kondensators zu kontrollieren und zu messen, und zwar mit Hilfe des Messwiderstands (4), mit Hilfe des Referenzwiderstands (3), und mit Hilfe des Messwiderstands und gleichzeitig des Referenzwiderstands (3,4), wobei der Messwiderstand (4) und der Referenzwiderstand (3) durch ein Kontrollelement parallel geschaltet werden können, um die Messung der beiden Widerstände gleichzeitig auszuführen, das Kontrollelement auf diese Weise den Wert des Messwiderstands und den Wert der gemessenen physikalische Grösse bestimmt.

2. Messkreis nach Anspruch 1, wobei mehrere Messwiderstände sich dafür eignen, durch das Kontrollbauelement parallel geschaltet zu werden.

3. Messkreis nach Anspruch 1 oder 2, wobei der Kondensator (2) mittels einer Stromquelle (5) geladen oder entladen wird, der dem Kondensator zugeführte Strom von einer Kontrolleinheit (6,7) überwacht wird, die mit jedem Widerstand (4,3) verbunden ist und ein Abbild des Stromes ist, der durch diesen Widerstand fliesst.

4. Messstromkreis nach einem der Ansprüche 1 bis 3, wobei der Messwiderstand (4) einen Wert hat, der von dem Temperaturwert abhängt.

5. Messkreis nach Anspruch 4, wobei der Messwiderstand (4) ein Platinfühler ist.

6. Temperaturmesskreis nach Anspruch 5, wobei das Kontrollbauelement die Temperatur durch die Lösung einer quadratischen Gleichung unter Verwendung des Widerstandswertes des Fühlers berechnet.

7. Temperaturmesskreis nach Anspruch 5, wobei das Kontrollbauteil die Temperatur berechnet, indem es eine lineare Näherung der Schwankung des Fühlerwiderstands und der Temperatur nutzt.

8. Temperaturmesskreis nach einem der Ansprüche 1 bis 6, wobei das Kontrollelement (1) ein Mikroprozessor ist.

**Claims**

1. A circuit for measuring a physical quantity comprising a capacitor (2), that can be charged or discharged using a reference resistor (3) and a measurement resistor (4), the measurement resistor having a value that depends on the value of a physical quantity, and a control device (1) that controls and measures the charging and discharging time of the capacitor, **characterized in that** the control device (1) is capable of controlling and measuring the charging and discharging time of the capacitor using the measurement resistor (4), using the reference resistor (3), and using the measurement resistor (4) and the reference resistor (3, 4) simultaneously, the reference resistor (3) being capable of being connected in parallel by the control device for measuring the two resistors simultaneously, the control device thus determining the value of the measurement resistor and the value of the physical quantity measured.

2. A measurement circuit according to Claim 1, wherein a plurality of measurement resistors are capable of being connected in parallel by the control device.

3. A measurement circuit according to Claim 1 or 2, wherein the capacitor (2) is charged or discharged by a current source (5), the current supplied to the capacitor being controlled by a control element (6, 7) associated with each resistor (4, 3) and being an image of the current circulating in said resistor.

4. A measurement circuit according to any one of Clams 1 to 3, wherein the measurement resistor (4) has a value that depends on the temperature value.

5. A measurement circuit according to Claim 4, wherein the measurement resistance (4) is a sensing element plate.

6. A circuit for measuring temperature according to Claim 5, wherein the control device calculates the temperature by solving a quadratic equation by utilizing the value of the resistance of the sensing element.

7. A circuit for measuring temperature according to Claim 5, wherein the control device calculates the temperature by utilizing a linear approximation of the resistance of the sensing element varying with temperature.

8. A circuit for measuring temperature according to any one of Claims 1 to 6, wherein the control device (1) is a microprocessor.

FIG.1

FIG. 2

EP 0 675 347 B1